(19) **Europäisches Patentamt**

**European Patent Office**

**Office européen des brevets**

(11) **EP 0 635 843 B1**

(12) **FASCICULE DE BREVET EUROPEEN**

(45) Date de publication et mention
de la délivrance du brevet:
**11.07.2001 Bulletin 2001/28**

(51) Int Cl.⁷: **G11C 27/02**

(21) Numéro de dépôt: **94202064.5**

(22) Date de dépôt: **15.07.1994**

(54) **Circuit échantillonneur differentiel**

Differenz-Abtast- und Halteschaltung

Differential sample and hold circuit

(84) Etats contractants désignés:
**DE FR GB IT**

(30) Priorité: **22.07.1993 FR 9309054**

(43) Date de publication de la demande:
**25.01.1995 Bulletin 1995/04**

(73) Titulaire: **Koninklijke Philips Electronics N.V.
5621 BA Eindhoven (NL)**

(72) Inventeur: **van de Plassche, Rudy
F-75008 Paris (FR)**

(74) Mandataire: **Chaffraix, Jean
Société Civile S.P.I.D.
156, Boulevard Haussmann
75008 Paris (FR)**

(56) Documents cités:
**EP-A- 0 398 778        EP-A- 0 446 880**

• **IEEE JOURNAL OF SOLID-STATE CIRCUITS,
vol.27, no.7, Juillet 1992, NEW YORK US pages
988 - 992 VORENKAMP ET AL 'Fully Bipolar,
120-Msample/s 10-b Track -and-Hold Circuit'**

## Description

La présente invention a pour objet un circuit echantillonneur differentiel. Elle concerne également un convertisseur analogique numérique constitué à partir d'un tel circuit échantillonneur, et un récepteur de télévision numérique qui comporte un tel convertisseur.

Dans le domaine du traitement numérique du signal, et notamment pour les récepteurs de télévision numériques, il est nécessaire de disposer de convertisseurs analogique/numérique dont les fréquences d'échantillonnage peuvent atteindre 2 à 3GHz.

Pour réaliser un circuit échantillonneur, il est connu d'utiliser un module suiveur-bloqueur différentiel tel que décrit dans l'article de Messieurs Vorenkamp et Verdaasdonk intitulé "Fully bipolar, 120 Msample/s 10-b track-and-hold circuit" et paru dans la revue "IEEE Journal of solid-state circuits" n°7 du mois de juillet 1992. Ce module comporte une cellule interrupteur composée d'un transistor qui, durant la période de suivi du signal d'entrée se comporte en émetteur-suiveur afin de charger une capacité d'enregistrement, et qui est polarisé en inverse durant la période de blocage de façon à maintenir en sortie le signal qui a été enregistré pendant la période de suivi. L'utilisation d'un tel transistor émetteur-suiveur comme interrupteur donne naissance à des oscillations en hautes fréquences. De plus, ce circuit présente une période de suivi puis une période de blocage de telle sorte qu'aucune conversion ne peut avoir lieu pendant la période de suivi. Les performances d'un tel circuit sont donc limitées en fréquences.

La présente invention a pour but de proposer un circuit échantillonneur remédiant à ces inconvénients.

Pour cela, un circuit échantillonneur différentiel selon l'invention est caractérisé en ce qu'il est constitué de deux parties qui comportent chacune au moins un multiplexeur d'entrée, deux modules suiveurs-bloqueurs à fonctionnement intercalé et un multiplexeur de sortie, lesdits modules suiveurs-bloqueurs comportant:

- une charge d'entrée permettant de commander lesdits modules suiveurs bloqueurs en mode suiveur ou en mode bloqueur, ladite charge d'entrée étant constituée à partir du trajet collecteur - émetteur d'un transistor dont la base et le collecteur sont reliés par l'intermédiaire d'une résistance,
- et une cellule interrupteur commune pour commander l'état passant ou non passant desdits transistors

L'utilisation, pour chaque partie du circuit différentiel, de deux modules suiveurs-bloqueurs intercalés permet de doubler la vitesse d'échantillonnage sans augmenter la vitesse intrinsèque du circuit. On notera à cet égard que la demande de brevet européen n°0 398 778 décrit un circuit échantillonneur bloqueur qui comporte deux voies parallèles identiques en vue d'augmenter la fréquence d'échantillonnage.

L'invention permet aussi de remédier aux problèmes d'oscillations à haute fréquence en évitant l'emploi d'un transistor émetteur suiveur comme interrupteur.

Dans un mode de réalisation préférentiel d'un circuit échantillonneur selon l'invention, chacun des modules multiplexeurs de sortie comprend une seconde paire différentielle de transistors, commandée par le second signal d'horloge, et qui permet elle-même de commander une troisième paire différentielle de transistors, les transistors des seconde et troisième paires étant connectés par une liaison collecteur-base, les émetteurs des transistors de la troisième paire constituant la sortie du circuit échantillonneur, leurs collecteurs étant connectés à la borne de tension d'alimentation, et leurs bases étant respectivement reliées aux émetteurs des seconds transistors des premier et second modules suiveurs-bloqueurs par l'intermédiaire d'une troisième et d'une quatrième résistance.

Ce multiplexage de sortie permet de sélectionner la sortie active.

Dans un autre mode de réalisation d'un circuit échantillonneur selon l'invention, chacun des modules multiplexeurs d'entrée comprend une quatrième paire différentielle de transistors, commandée par le premier signal d'horloge et dont les transistors sont respectivement reliés par leur collecteur aux entrées des premier et second modules suiveurs-bloqueurs.

Ce multiplexage d'entrée détermine l'instant exact d'échantillonnage qui est indépendant du niveau du signal d'entrée. C'est un avantage supplémentaire par rapport au circuit décrit dans l'art antérieur précité.

D'autres particularités, détails et avantages de la présente invention seront mis en évidence par la description qui va suivre en regard des dessins annexés qui sont relatifs à des exemples donnés à titre non limitatif dans lesquels :

- la figure 1 est un schéma de principe d'un exemple de circuit échantillonneur selon l'invention,
- la figure 2 est un schéma d'un exemple détaillé de circuit échantillonneur selon l'invention.

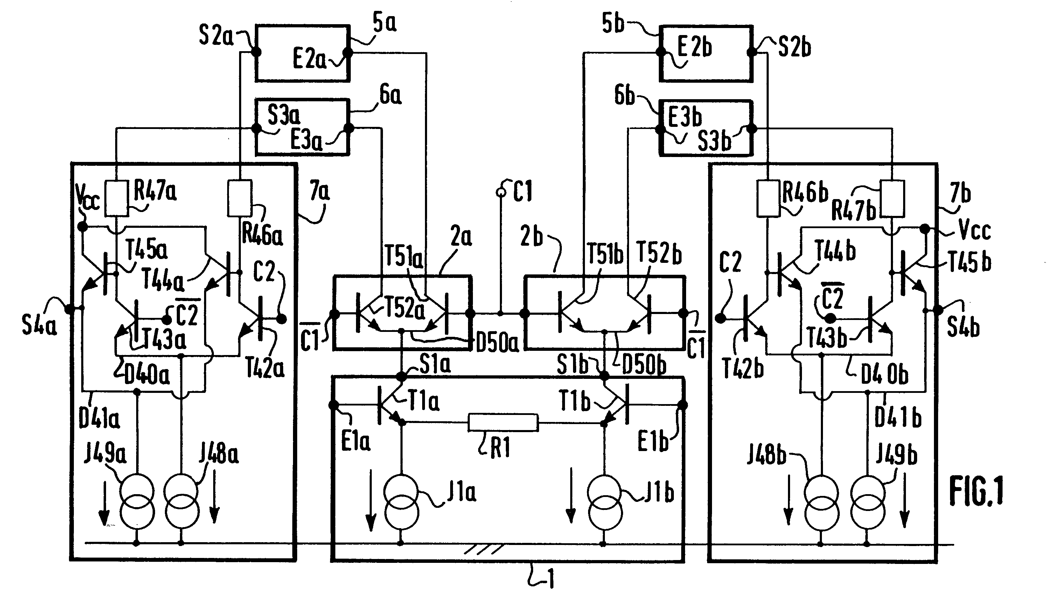

La figure 1 représente un circuit échantillonneur différentiel composé d'une première et d'une seconde partie de même structure. Les éléments homologues de ces première et seconde parties portent les mêmes références respectivement indicées par les lettre a et b.

D'après la figure 1, un circuit échantillonneur selon l'invention comporte deux entrées différentielles E1a et E1b recevant respectivement le signal d'entrée et son inverse, ainsi que deux sorties différentielles S4a et S4b délivrant deux signaux de sortie inverses l'un de l'autre. Il comporte également un convertisseur tension-courant 1 dont les deux entrées E1a et E1b sont celles du circuit échantillonneur, et qui dispose de deux sorties S1a et S1b. A ces sorties S1a et S1b sont respectivement connectées la première et la seconde partie du circuit échantillonneur différentiel. Ainsi, la sortie S1a du convertisseur tension-courant 1 est connectée par l'intermédiaire d'un module multiplexeur d'entrée 2a aux entrées E2a et E3a d'un premier et d'un second modules suiveurs-bloqueurs 5a et 6a. Les sorties S2a et S3a de ces modules suiveurs-bloqueurs 5a et 6a sont connectées à une sortie S4a du circuit échantillonneur par l'intermédiaire d'un module multiplexeur de sortie 7a. De même, la sortie S1b du convertisseur tension-courant 1 est connectée par l'intermédiaire d'un module multiplexeur d'entrée 2b aux entrées E2b et E3b d'un premier et d'un second modules suiveurs-bloqueurs 5b et 6b. Les sorties S2b et S3b de ces modules suiveurs-bloqueurs 5b et 6b sont connectées à la sortie S4b du circuit échantillonneur par l'intermédiaire d'un module multiplexeur de sortie 7b.

Le convertisseur tension-courant 1 est composé de deux transistors T1a et T1b dont les bases constituent les entrées E1a et E1b du circuit échantillonneur, dont les émetteurs sont d'une part reliés entre eux par l'intermédiaire d'une résistance R1, et d'autre part reliés à la masse par l'intermédiaire de deux sources de courant J1a et J1b respectivement, et dont les collecteurs constituent respectivement les sorties S1a et S1b du convertisseur tension-courant.

Les modules multiplexeurs d'entrée 2a et 2b sont constitués chacun d'une paire différentielle de transistors D50a et D50b comportant deux transistors T51a et T52a d'une part, et T51b et T52b d'autre part. Les émetteurs des deux transistors T51a et T52a sont donc reliés à la sortie S1a du convertisseur tension-courant 1, tandis que ceux des transistors T51b et T52b sont reliés à sa sortie S1b. Les collecteurs des transistors T51a et T52a sont respectivement connectés aux entrées E2a et E3a des modules suiveurs-bloqueurs 5a et 6a, tandis que ceux des transistors T51b et T52b sont connectés aux entrées E2b et E3b des modules suiveurs-bloqueurs 5b et 6b. Enfin, les bases des transistors T51a et T51b reçoivent un premier signal d'horloge C1, tandis que celles des transistors T52a et T52b reçoivent l'inverse $\overline{C1}$ de ce premier signal d'horloge.

Le module multiplexeur de sortie 7a est constitué de deux paires différentielles de transistors D40a et D41a. La paire différentielle de transistors D40a est composée de deux transistors T42a et T43a dont les émetteurs sont respectivement reliés à la masse par l'intermédiaire d'une source de courant J48a, dont les bases reçoivent respectivement un second signal d'horloge C2 et son inverse $\overline{C2}$, et dont les collecteurs, qui sont en outre respectivement connectés aux sorties S2a et S3a des modules suiveurs-bloqueurs 5a et 6a par l'intermédiaire de deux résistances R46a et R47a, permettent de commander la paire différentielle de transistors D41a. Cette paire différentielle de transistors D41a est en effet composée de deux transistors T44a et T45a dont les bases sont connectées aux collecteurs des transistors T42a et T43a. Les émetteurs des transistors T44a et T45a sont reliés d'une part à la masse par l'intermédiaire d'une source de courant J49a, et d'autre part à la sortie S4a du circuit échantillonneur. Leurs collecteurs, enfin, sont reliés à une borne de tension d'alimentation Vcc.

De même, le module multiplexeur de sortie 7b est constitué de deux paires différentielles de transistors D40b et D41b. La paire différentielle de transistors D40b est composée de deux transistors T42b et T43b dont les émetteurs sont respectivement reliés à la masse par l'intermédiaire d'une source de courant J48b, dont les bases reçoivent respectivement un second signal d'horloge C2 et son inverse $\overline{C2}$, et dont les collecteurs, qui sont en outre respectivement connectés aux sorties S2b et S3b des modules suiveurs-bloqueurs 5b et 6b par l'intermédiaire de deux résistances R46b et R47b, permettent de commander la paire différentielle de transistors D41b. Cette paire différentielle de transistors D41b est en effet composée de deux transistors T44b et T45b dont les bases sont connectées aux collecteurs des transistors T42b et T43b. Les émetteurs des transistors T44b et T45b sont reliés d'une part à la masse par l'intermédiaire d'une source de courant J49a, et d'autre part à la sortie S4b du circuit échantillonneur. Leurs collecteurs, enfin, sont reliés à la borne de tension d'alimentation Vcc.

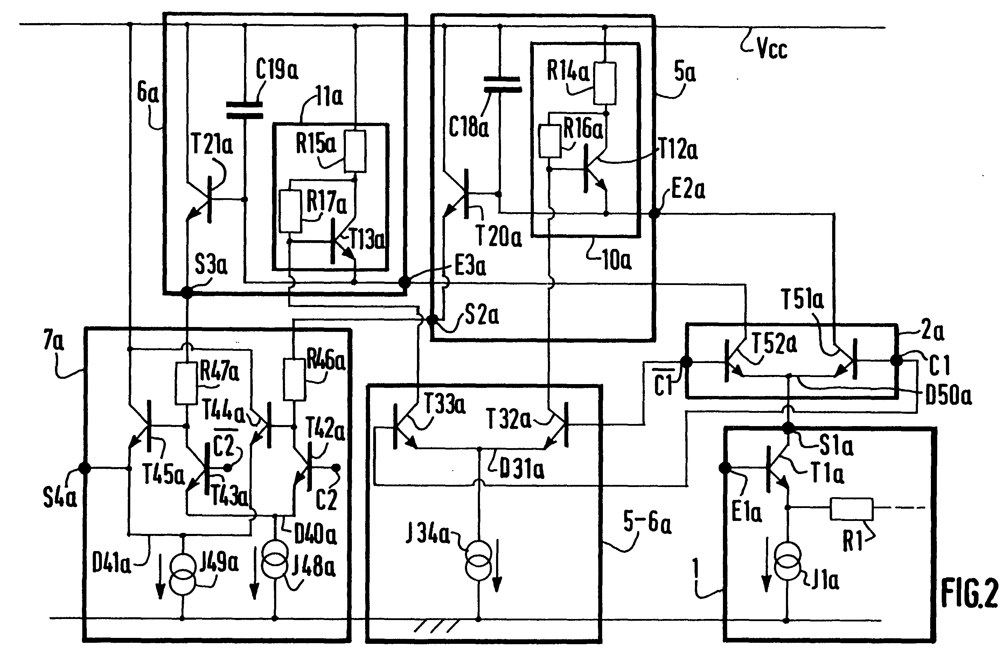

La figure 2 représente un exemple détaillé de la première partie d'un circuit échantillonneur différentiel selon l'invention. La seconde partie d'un tel circuit s'en déduit aisément.

D'après la figure 2, chaque module suiveur-bloqueur 5a (et 6a) comporte une charge d'entrée 10a (et 11a) comprenant un transistor T12a (et T13a) dont le collecteur est relié à la borne de tension d'alimentation Vcc par l'intermédiaire d'une résistance R14a (et R15a), dont la base est reliée au collecteur par l'intermédiaire d'une résistance R16a (et R17a) et dont l'émetteur constitue l'entrée E2a (et E3a) du module suiveur-bloqueur 5a (et 6a). Il comporte de plus une capacité C18a (et C19a) connectée entre la borne de tension d'alimentation Vcc et l'entrée E2a (et E3a) du module suiveur-bloqueur 5a (et 6a), ainsi qu'un transistor de sortie émetteur-suiveur T20a (et T21a) dont la base est connectée à ladite entrée E2a (et E3a), dont le collecteur est relié à la borne de tension d'alimentation Vcc, et dont l'émetteur constitue la sortie S2a (et S3a) du module suiveur-bloqueur 5a (et 6a). Ces modules suiveurs-bloqueurs 5a et 6a comportent également une cellule interrupteur 5-6a, commune aux deux modules, comportant une paire différentielle de transistors D31a comprenant deux transistors T33a et T32a, dont les bases reçoivent respectivement le premier signal d'horloge C1 et son inverse $\overline{C1}$, dont les émetteurs sont reliés à la masse par l'intermédiaire d'une source de courant J34a, et dont les collecteurs sont respectivement reliés aux bases des transistors T13a et T12a des modules suiveurs-bloqueurs 6a et 5a.

Dans la suite de la description, on suppose que les niveaux des premier et second signaux d'horloge C1 et C2 sont hauts, c'est-à-dire que les niveaux de leurs inverses $\overline{C1}$ et $\overline{C2}$ sont bas. Le module suiveur-bloqueur 5a fonctionne donc en mode suiveur tandis que le module suiveur-bloqueur 6a fonctionne en mode bloqueur.

En effet, la cellule interrupteur 5-6a permet de polariser en direct le transistor T12a, tandis que le transistor T13a est polarisé en inverse : la base du transistor T32a étant basse, c'est le transistor T33a qui conduit, imposant un courant de collecteur dans la résistance R17a. La chute de tension aux bornes de cette résistance est alors suffisamment importante pour que le transistor T13a soit bloqué. La capacité C19a est alors déconnectée de la charge d'entrée 11a, et le module suiveur-bloqueur 6a est placé en mode bloqueur. Au contraire, le courant qui circule dans la résistance R16a n'est qu'un courant de base, suffisamment faible pour que le transistor T12a conduise. Ainsi, le signal d'entrée est transformé en courant par le convertisseur tension-courant 1, et ce courant circule dans la charge 10a du module suiveur-bloqueur 5a et dans le transistor T51a du module multiplexeur d'entrée 2a puisque la base de ce dernier est haute, permettant donc de charger ou de décharger la capacité C18a.

En sortie, la base du transistor T42a étant haute, un courant collecteur est imposé dans la résistance R46a, entraînant une chute de potentiel sur la base du transistor T44a. C'est donc le transistor T45a qui conduit, recopiant sur la sortie S4a du circuit échantillonneur la tension présente aux bornes de la capacité C19a.

A l'inverse, lorsque les niveaux des premier et second signaux d'horloge C1 et C2 sont bas, le module suiveur-bloqueur 5a fonctionne en mode bloqueur tandis que le module suiveur-bloqueur 6a fonctionne en mode suiveur.

Bien que l'invention ait été décrite d'après un exemple concret de réalisation, il reste entendu que des variantes facilement imaginables par l'homme de l'art sont possibles, et que ces variantes appartiennent au domaine de l'invention.

## Revendications

**1.** Circuit échantillonneur différentiel caractérisé en ce qu'il est constitué de deux parties qui comportent chacune au moins un multiplexeur d'entrée (2a, 2b), deux modules suiveurs-bloqueurs à fonctionnement intercalé (5a et 6a, 5b et 6b) et un multiplexeur de sortie (7a, 7b), lesdits modules suiveurs-bloqueurs comportant:

- une charge d'entrée (10a, 11a) permettant de commander lesdits modules suiveurs Moqueurs en mode suiveur ou en mode bloqueur, ladite charge d'entrée étant constituée à partir du trajet collecteur - émetteur d'un transistor (T12a, T13a) dont la base et le collecteur sont reliés par l'intermédiaire d'une résistance (R16a, R17a),

- et une cellule interrupteur commune (5-6a) pour commander l'état passant ou non passant desdits transistors

**2.** Convertisseur analogique numérique caractérisé en ce qu'il comporte un circuit échantillonneur différentiel selon la revendication 1.

**3.** Récepteur de télévision numérique caractérisé en ce qu'il comporte au moins un convertisseur analogique selon la revendication 2.

## Claims

**1.** A differential sample and hold circuit, characterized in that it is formed by two parts comprising each at least one input multiplexer (2a, 2b), two interposed track-and-hold modules (5a, 6a; 5b, 6b) and an output multiplexer (7a, 7b), said track-and-hold modules including:

- an input load (10a, 11a) permitting to control said track-and-hold modules in the tracking mode or blocking mode, said input load being formed based on the collector-emitter path of a transistor (T12a, T13a) whose base and collector are connected via a resistor (R16a, R17a),

and a common switch cell (5-6a) to control the on or off mode of said transistors.

**2.** An analog to digital converter, characterized in that it comprises a differential sample and hold circuit as claimed in claim 1.

**3.** A digital television receiver, characterized in that it comprises at least an analog converter as claimed in claim 2.

## Patentansprüche

**1.** Differenz-Abtast- und Halteschaltung, dadurch gekennzeichnet, daß sie aus zwei Teilen gebildet wird, die jeweils mindestens einen Eingangsmultiplexer (2a, 2b), zwei versetzt arbeitende Sperr-Folge-Module (5a und 6a, 5b und 6b) und einen Ausgangsmultiplexer (7a, 7b) enthält, wobei die besagten Sperr-Folge-Module folgendes aufweisen:

- Eine Eingangsladung (10a, 11a) zum Steuern der besagten Sperr-Folge-Module in Folge- oder Sperrbetrieb, wobei die besagte Ladung über den Weg Kollektor-Emitter eines Transistors (T12a, T13a) gebildet wird, dessen Basis und Kollektor über einen Widerstand (R16a, R17a) verbunden sind,

- und eine gemeinsame Unterbrecherzelle (5-6a), zum Steuern, ob der Zustand der besagten Transistoren durchlässig ist oder nicht.

2. Analog-Digital-Wandler, dadurch gekennzeichnet, daß sie eine Differenz-Abtast- und Halteschaltung nach Anspruch 1 enthält.

3. Digitaler Fernsehempfänger, dadurch gekennzeichnet, daß er mindestens einen Analog-Wandler nach Anspruch 2 enthält.

FIG.1

EP 0 635 843 B1

FIG.2